Europäisches Patentamt

European Patent Office

Office européen des brevets

(19)

(11) EP 1 406 291 A2

(12) **EUROPEAN PATENT APPLICATION**

(43) Date of publication:
07.04.2004 Bulletin 2004/15

(51) Int Cl.7: **H01J 37/317**, H01J 37/304

(21) Application number: 03022163.4

(22) Date of filing: 30.09.2003

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **02.10.2002 JP 2002289879**

(71) Applicant: **Hitachi High-Technologies Corporation
Tokyo 105-8717 (JP)**

(72) Inventors:
• **Onishi, Takashi, Hitachi High-Techologies Corp.**
  **Minato-ku, Tokyo 105-8717 (JP)**
• **Mizuochi, Masaki,**
  **Hitachi High-Technologies Corp.**
  **Minato-ku, Tokyo 105-8717 (JP)**

(74) Representative: **Strehl Schübel-Hopf & Partner
Maximilianstrasse 54
80538 München (DE)**

(54) **Electron beam lithography system and method**

(57) An object of the present invention is to provide an electron beam lithography system and an electron beam lithography method that reduce drawing discrepancy caused by thermal expansion of a target wafer, and that thereby easily achieve drawing with a high degree of accuracy.

There is provided an electron beam lithography system that draws circuit patterns on a target wafer 1 by use of an electron beam 3, said electron beam lithography system including an electro-optic system 106 and a target chamber 108. A computer 103 used for calculating thermal deformation is provided outside a control computer 101. When the application of the electron beam 3 increases a temperature of the target wafer 1, the amount of discrepancy caused by thermal deformation is calculated from a dose of the electron beam 3. Then, by handling the amount of discrepancy as compensation data used for a drawing program to be supplied to an electron beam deflector 107, the effect of the thermal deformation is compensated.

FIG. 1

EP 1 406 291 A2

**Description**

BACKGROUND OF THE INVENTION

The present invention relates to a lithography technique by an electron beam, and more particularly to an electron beam lithography system and an electron beam lithography method which are suitable for drawing circuit patterns on a semiconductor wafer.

As a kind of circuit-pattern formation technique, there is an electron beam lithography technique, which is broadly applied to the formation of circuit patterns on a semiconductor wafer in recent years. The problem of this technique is how to improve the accuracy of drawing.

Factors which determine the accuracy of drawing (that is to say, the position accuracy of an electronic beam applied on a target wafer such as a semiconductor wafer) include not only a disturbance caused by the surrounding environment but also the accuracy of target-wafer positioning provided by a stage, the accuracy of beam position control provided by an electron beam deflector, and deformation caused by a change in temperature of the target wafer.

In this case, the change in temperature of the target wafer mainly means an increase in temperature. The increase in temperature is caused not only by external factors including heat generation of a coil of electromagnetic lens provided in electron beam applying apparatus, and frictional heat of a stage, but also by an internal factor, that is to say, an increase in temperature due to thermal energy given to a target wafer when an electron beam is applied to the target wafer to draw a pattern.

The increase in temperature caused by the former, namely the external factor, is a matter that can be theoretically solved by an improvement in design of thermal transmission such as the stage, and with the addition of a cooling mechanism. However, the increase in temperature caused by the latter, namely the internal factor, is a matter that is considerably difficult to be solved because in the first place the electron beam lithography system itself is based on the basic processing principle in which energy is given to a target wafer by an electron beam.

As far as the electron beam lithography system is concerned, the circuit patterns are drawn on a target wafer by use of the kinetic energy of an electron beam. Because the drawing accuracy of the electron beam is very high in comparison with a size of the target wafer, and is on the order of several nanometers, a discrepancy in position including thermal expansion of the target wafer becomes a major problem.

In the conventional techniques, thermal transmission to a target wafer is prevented by providing a stage of which heat generation is reduced, and by designing a cooling mechanism of the stage so that radiation of heat may be performed efficiently.

However, the techniques for preventing thermal transmission to a target wafer are accompanied by the thermal interception to the target wafer. Such thermal interception conversely results in a larger influence on the increase in temperature and the thermal expansion which are caused by energy directly given to the target wafer at the time of the electron beam lithography. It is because heat generated by an electron beam is kept in an area around a target holder, hindering diffusion of thermal energy of the target wafer.

This problem can be improved by providing a heat dissipation mechanism, for instance, by providing a stage with a pipe of coolant. In this case, however, providing such a mechanism does not reach an ultimate solution because a bottleneck is produced in the design in which the target holder must not be in contact with other parts, and further because a delay caused by the cooling, and stability of temperature of coolant, become new problems.

What is more, as for the heat from the target holder as a kind of the external factors, if thermal insulating design which intends to suppress the thermal transmission to the target wafer is made in this manner, the thermal transmission from the target wafer to outside is hindered as described above, exerting larger influence of the internal factor on the contrary. Because this presents an antinomy, it is more difficult to solve the problem.

For this reason, in one of the prior art, the influence of the thermal expansion of the target wafer is reduced by measuring a temperature of the target wafer, and by providing a reference point on the target wafer so that it becomes possible to draw a circuit pattern with reference to the reference point , and further by determining the total amount of energy given to the target wafer to calculate the absolute temperature of the target wafer so that the extent of the thermal expansion of the target wafer is measured and estimated (for example, refers to patent document 1).

[Patent document 1]

Japanese Patent Laid-Open No. Hei 9-251941

SUMMARY OF THE INVENTION

As far as the above-mentioned prior art is concerned, an electron beam is partially applied to the target wafer, which causes partial distribution of temperature in the target wafer. This is a point that is not taken into consideration. Thus, there is a problem when improving the accuracy of compensation of thermal expansion.

An object of the present invention is to provide an electron beam lithography system and an electron beam lithography method that reduce the influence on drawing discrepancy caused by thermal expansion of a target wafer, and that thereby easily achieve high accuracy drawing.

In order to achieve the above-mentioned object, there is provided an electron beam lithography system of a type in which an electron beam is scanned according to a predetermined drawing program to draw circuit patterns on a target wafer, the system comprising:

a calculating means that calculates beforehand thermal deformation occurring in the target wafer, the thermal deformation being caused by the application of the electron beam, calculates from the result of the calculation compensation data required to compensate the amount of discrepancy in electron-beam applying position, and then stores the compensation data; and
a control means that compensates at the time of electron beam lithography, according to the compensation data read out from the calculating means, at least one of a dose and an applying position of the electron beam applied according to the drawing program.

Similarly, in order to achieve the above-mentioned object, there is provided an electron beam lithography system of a type in which an electron beam is scanned according to a drawing program that is predetermined but can also be changed to draw circuit patterns on a target wafer, the system comprising:

a calculating means that calculates thermal deformation occurring in the target wafer, said thermal deformation being caused by the electron beam applied according to the drawing program, and calculates from the result of the calculation compensation data required to compensate the amount of discrepancy in electron-beam applying position; and
a control means that compensates, according to the compensation data read out from the calculating means, at least one of a dose and an applying position of the electron beam applied according to the drawing program;

wherein said calculating means calculates the compensation data in real time at the time of electron beam lithography.

In this case, said calculating means may also calculate the compensation data by means of computer simulation.

Moreover, in order to achieve the above-mentioned object, there is provided an electron beam lithography method of a type in which an electron beam is scanned according to a predetermined drawing program to draw circuit patterns on a target wafer, said method comprising the steps of:

calculating beforehand thermal deformation occurring in the target wafer, said thermal deformation being caused by the application of the electron beam;
calculating from the result of the calculation compensation data required to compensate the amount of discrepancy in electron-beam applying position, and then storing the compensation data; and
compensating at the time of electron beam lithography, according to the compensation data, at least one of a dose and an applying position of the electron beam applied according to the drawing program.

Moreover, in order to achieve the above-mentioned object, there is provided an electron beam lithography system of a type in which.an electron beam is scanned according to a drawing program that is predetermined but can also be changed to draw circuit patterns on a target wafer, said method comprising the steps of:

calculating thermal deformation occurring in the target wafer, said thermal deformation being caused by the electron beam applied according to the drawing program;
calculating from the result of the calculation compensation data required to compensate the amount of discrepancy in electron-beam applying position; and
compensating, according to the compensation data read out from the calculating means, at least one of a dose and an applying position of the electron beam applied according to the drawing program;

wherein the compensation data is calculated in real time at the time of electron beam lithography.

In this case, said step for calculating the compensation data may also be a step for calculating the compensation data by means of computer simulation.

BRIEF DESCRIPTION OF THR DRAWINGS

Fig. 1 is a block diagram illustrating one embodiment of an electron beam lithography system according to the present invention.
Fig. 2 is a plan view illustrating a positioning state of a target wafer on a wafer stage.
Fig. 3 is a plan view illustrating an example of non-parallel expansion of a target wafer.
Fig. 4 is a cross section illustrating an example of 3-dimensional deformation of a target wafer.
Fig. 5 is a conceptual diagram illustrating an example of an electron-beam applying position compensating method according to one embodiment of the present invention.
Fig. 6 is a flowchart illustrating processing steps in one embodiment according to the present invention.

Fig. 7 is a conceptual diagram illustrating calculation of thermal diffusion according to one embodiment of the present invention.

## DESCRIPTION OF THE PREFERRED EMBODIMENTS

An electron beam lithography system, and an electron beam lithography method, according to the present invention will be explained in detail with reference to embodiments shown in drawings as below.

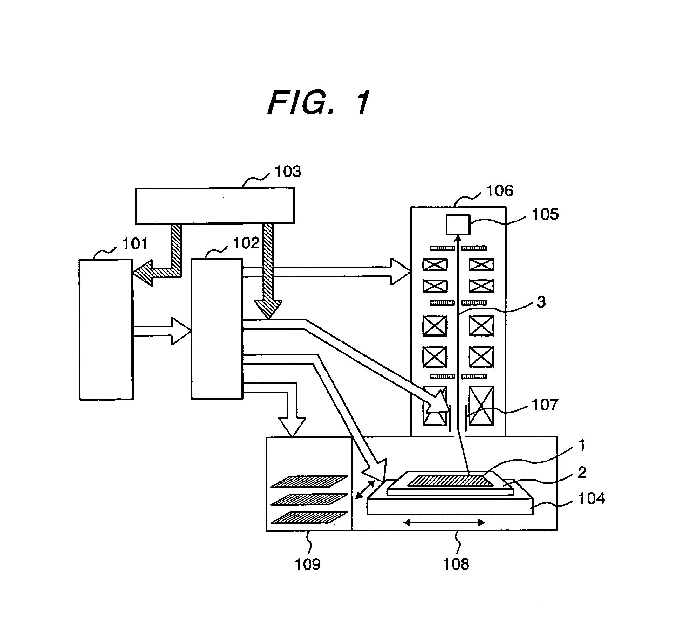

To begin with, Fig. 1 is a diagram illustrating one embodiment according to the present invention. Here, reference numeral 106 denotes an electro-optic system, and reference numeral 108 denotes a target loader. In a broad sense, they constitute the electron beam lithography system. Next, reference numeral 1 is a target, that is to say, a semiconductor wafer on which, for example, circuit patterns are drawn according to a predetermined drawing program.

This target wafer 1 is held on a target holder 2, and is positioned by a stage 104. At this time, the target holder 2 is housed in a vacuum chamber 108 that totally communicates with a target loader (loader) 109 and the electro-optic system 106.

In this case, a control computer 101 controls the stage 104, the electro-optic system 106, and the target loader 108 through a control system 102 according to a predetermined drawing program. Because the control system 102 includes a power supply system, the control system 102 also has a function of providing the electro-optic system 106 with power supply required for operation.

The electro-optic system 106 includes a beam converging means for focusing an electron beam 3 emitted from an electron source 105 by use of an electromagnetic lens, and a beam scanning unit 107 for scanning an electron-beam applying position on the target wafer 1. The electro-optic system 106, therefore, has a function of applying the electron beam to the target wafer 1 to draw circuit patterns, or the like, according to a predetermined drawing program.

Here, to provide the amount of deflection of the electron beam given by a beam deflector 107, the amount of deflection which is calculated from a dose and an applying position of the electron beam by use of a thermal-deformation calculating computer 103 is used as the amount of compensation. This is a feature of this embodiment. How to calculate the amount of deflection will be described as below.

If the target wafer 1 is thermal-insulated from surroundings, the heat which is given to the target wafer 1 by the electron beam 105 causes thermal expansion of the target wafer 1, leading to three kinds of deformation mentioned below, each of which produces a discrepancy in position to which an electron beam is applied.

Here, the three kinds of deformation include parallel expansion, non-parallel expansion, and 3-dimensional deformation (bend or curvature), which will be specifically described as below.

<Parallel expansion>

The parallel expansion is a phenomenon in which thermal energy uniformly spreads through the whole target wafer, causing the target wafer to expand as a whole and consequently to grow in planar size. In this case, the thermal expansive force of a crystal forming the target wafer is in general stronger than the force that secures the target wafer to a stage. Therefore, even if the target wafer is secured, it is difficult to compulsorily prevent the discrepancy caused by the thermal expansion from occurring.

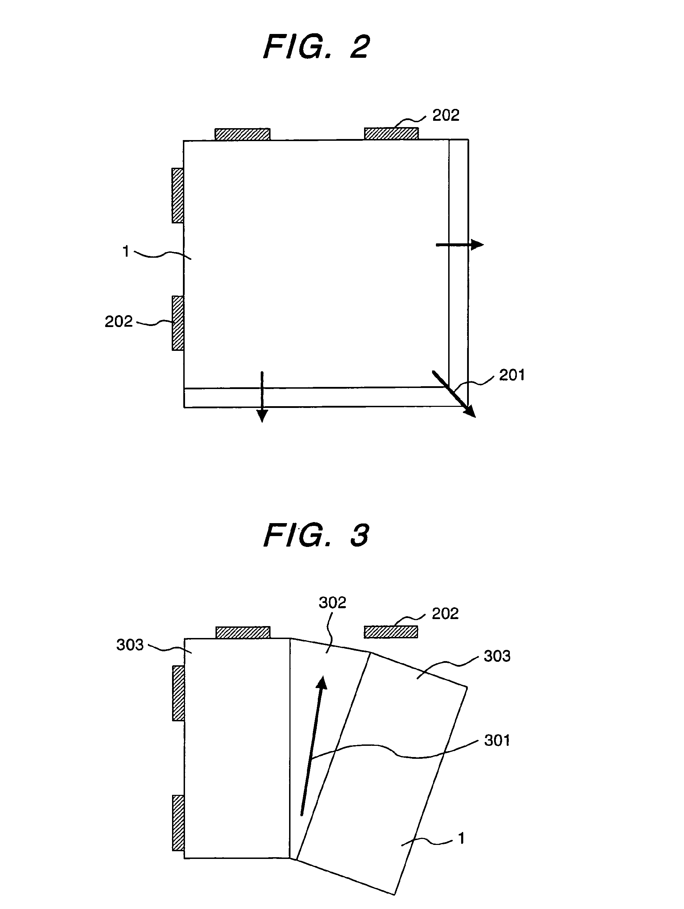

From a practical standpoint, in the case of a rectangle target wafer 1 having four side edges as shown in Fig. 2, two side edges are positioned and fixed by stoppers. 202 to use the two side edges as fixing points, whereas the other two side edges are free as they are. As a result, an arbitrary point on the target wafer 1 moves due to the thermal expansion so that a movement 201 in response to a distance from the fixing point is easily attained.

Now, if applying an electron beam increases a temperature of the target wafer 1 by $\Delta T$, a certain point on the target wafer 1 moves by $\Delta d = \Delta T d a$, where a distance from the fixing point to the certain point is d and an expansion rate is a.

Here, on the assumption that specific heat of the target wafer 1 is $Cp$ and a density is $\rho$, an average increase in temperature $\Delta T$ of the target wafer 1 can be expressed as $\Delta T = E/Cp\rho$ by use of integrated thermal energy E given to the target wafer as a result of drawing. After all, the moving distance $\Delta d$ is proportional to the integrated thermal energy E given to the target wafer 1 by the electron beam, and is therefore expressed as $\Delta d = Eda/Cp\rho$.

To be more specific, in the case of this simplified model, it is found out that a moving distance, and its direction, of the movement caused at certain time by the thermal expansion at a point where a pattern should be drawn on the target wafer 1 by an electron beam are uniquely determined by a relative position of the drawing position relative to the fixing point, and by an integrated value of the thermal energy which has been given to the target wafer 1 by the electron beam.

<Non-parallel expansion>

Next, the non-parallel expansion is a phenomenon in which thermal energy is locally given to a target wafer, resulting in uneven thermal expansion of the target wafer, and causing a plane shape to change.

In general, the target wafer 1 has thermal conductivity. As shown in Fig. 3, the thermal energy which has been given to a part of the target wafer 1 (part 302) by use of an electron beam spreads through the whole target wafer 1 in a finite period of time.

Accordingly, if a pattern is drawn along a line 301 in a constant direction as described in the figure, a stress is applied to an area between peripheries 303 to which heat is not yet transmitted, while providing temperature distribution as a whole. Consequently, fixing of the positions by the stoppers 202 results in uneven expansion, which causes a plane shape to change.

Incidentally, because the working described above depends on a drawing order, a pattern, a temporal change in electron-beam energy, and a temporal change in electron-beam electric current, it is not possible to obtain a solution analytically. Therefore, there is no other choice but to obtain a numerical solution on the basis of a total drawing program.

<3-dimensional deformation>

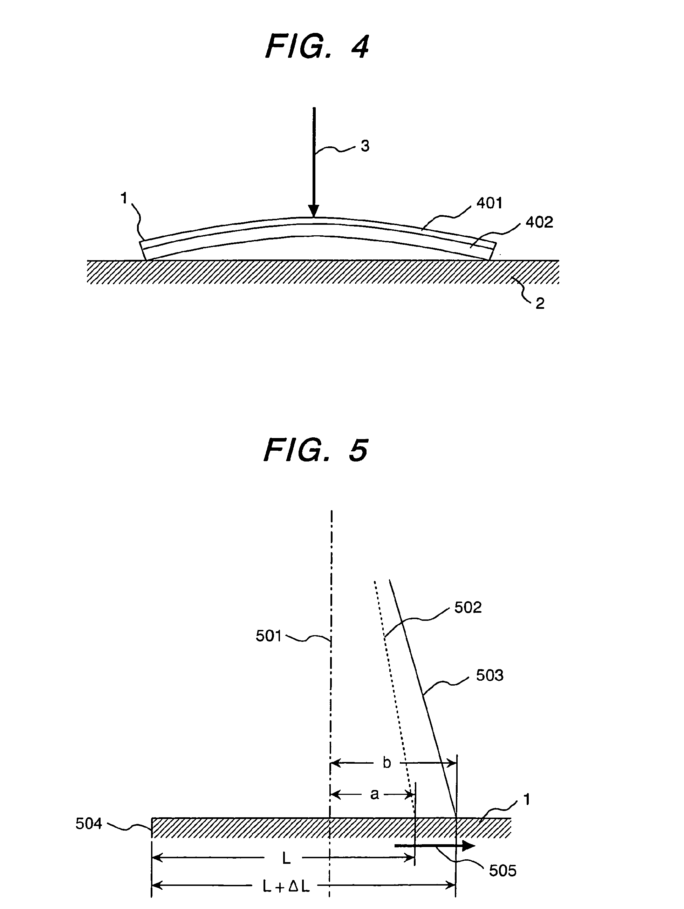

The 3-dimensional deformation (bend) means a phenomenon in which if thermal energy given by an electron beam stays near a surface of the target wafer that is relatively thick, its thermal expansion differs between the front surface and the back surface, and consequently, as shown in Fig. 4, the target wafer bends backward, causing an area around an applying position of the electron beam 3 (a central part in the figure) to be deformed in a direction away from the stage.

Accordingly, although this is also a kind of deformation caused by the thermal expansion, temperature distribution in a thickness direction of the target wafer should be taken into consideration, which is a different point. The deformation, therefore, occurs in a three-dimensional manner.

To keep track of this kind of deformation, it is necessary to obtain a numerical solution. However, if simplified drawing is used, on the assumption that an average temperature of a top surface 401 of the target wafer is $T1$, and that an average temperature of an under surface 402 of the target wafer is $T2$, a center of the target wafer placed on a plane is raised by a value determined by the following equation:

$$s = d^2 (T1 - T2)/8t(T2 - T0 + 1/a)$$

where a thickness of the target wafer is $t$, a diameter of the target wafer is $d$, and an expansion rate of the target wafer is $a$.

In particular, if the average temperature $T2 = T0$, the equation can be simplified as follows:

$$s = d^2 (T1 - T0)a/8t$$

This means a discrepancy from an applying plane of the electron-beam applying position toward a direction of a beam application axis. Accordingly, some compensation for a focus position of the electron beam may be required. In addition, same as the case of the parallel expansion and the non-parallel expansion, a secondary effect is produced also on discrepancy in electron-beam applying position.

Therefore, if it is assumed that the temperature distribution on the target wafer is uniform, in other words, if it is assumed that speed of thermal diffusion is equivalent to a limit that is infinite, a movement (change) of the drawing position, which is caused by the thermal expansion of the target wafer, can be expressed by a simple equation as a function of the total amount of energy given by the electron beam.

However, because the application of the energy to the target wafer by the electron beam, and its diffusion, are in general transient phenomena, it is necessary to acquire thermal diffusion on the target wafer by using numerical calculation, and thereby to acquire temperature distribution on the target wafer.

In the embodiment of the present invention, as an example, the temperature distribution on the target wafer is acquired using a simulation model. This means will be described as below.

To start with, a model for computer simulation is built. Accordingly, if the target wafer and the stage are well heat-insulated, it is assumed that the thermal balance of the target wafer is limited to three kinds of processes, that is to say, application of energy by an electron beam, diffusion of the energy through the whole target wafer, and thermal transmission by radiation into a target chamber.

Process 1: Application of energy by electron beam

The electron beam applied to the target wafer gives energy to a narrow range of area around an electron-beam applied part of the target wafer, and most of the energy is then absorbed in the target wafer. An applying position, applying time, and applying intensity of this electron beam are provided beforehand to the electron beam lithography system in a form of data containing a program as drawing patterns to be drawn on the target wafer. Accordingly, they are completely predictable.

Process 2: Diffusion of the energy through the whole target wafer

If the target wafer is well thermal-insulated, a difference in temperature in the target wafer is caused by the thermal energy imbalance in the target wafer. Then, in response to thermal gradient and thermal conductivity of the target wafer, and according to the well-known diffusion equation, the energy spreads out in directions that lessen the difference in temperature.

These processes and time required for them can be calculated with a high degree of accuracy by use of a classical model. In addition, a technique for calculating them in a quantized manner by use of a computer simulation is also well known. This is a technique having a high degree of reliability which is verified with excellent repeatability.

Process 3: Thermal transmission by radiation into a target chamber

Because the target wafer heated by the electron beam is placed in the vacuum target chamber, the target wafer loses the energy mainly due to radiation, and therefore slowly reaches a thermal equilibrium state. This process can be expressed by a quantum mechanical equation based on the assumption of black body radiation that depends on a surface temperature. The equation enables estimation with sufficient accuracy as correction factors of the process 1 and the process 2.

Next, numerical calculation will be described. Here, a field corresponding to one chip (usual, about 3 mm) on a surface of the target wafer is divided into areas, each of which corresponds to a subfield having a side length of 100 pm. The numerical calculation is performed by use of the areas.

The accuracy of the calculation increases with decrease in size of the area approximately within a range of the smallest electron-beam diameter (up to 100 nm). On the contrary, time required for the calculation increases. Accordingly, when calculating distortion caused by thermal expansion, dividing a field into areas, each of which has a size of about 100 $\mu$m, is practical.

In this case, if it is necessary to consider thermal distribution in a beam axis direction because the target wafer is thick, this area should be treated as a three-dimensional cube. Accordingly, three-dimensional numerical calculation of thermal conduction should be further performed.

To begin with, a temperature at certain time, and a size (length and width) after the thermal expansion, are given to this area as parameters for computer simulation. Next, when the temperature increases as a result of provided energy of an electron beam applied at certain time (however, only when the electron beam is applied to the area at that time), new temperature distribution after a lapse of unit time is recalculated as a numerical solution of the diffusion equation.

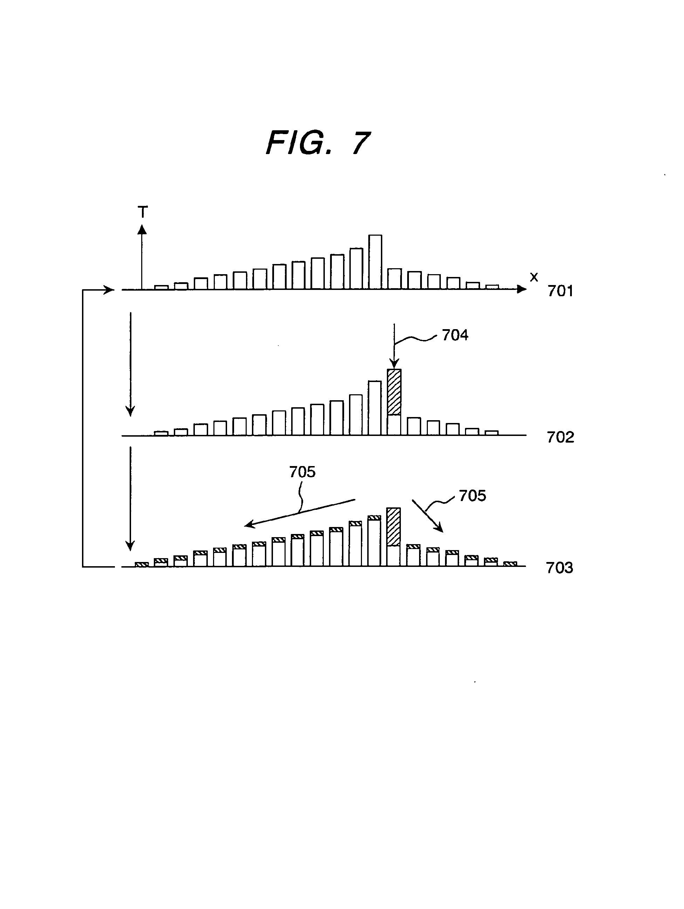

Next, for better understanding, a case where one-dimensional area is used will be described with reference to Fig. 7. Here, it is assumed that a target wafer at this time has thermal distribution (certain thermal distribution) as shown in a graph 701 where horizontal and vertical axes indicate a position x and a temperature T respectively.

Next, if an electron beam 704 gives energy to this target wafer at time t as shown in a graph 702, thermal diffusion 705 occurs as shown in a graph 703, resulting in temperature distribution at time t + $\Delta$t as illustrated in the figure.

If each area is observed, on the assumption that a certain area has a temperature T(t, x) at time t, a temperature T(t + $\Delta$t, x) of the area at time t + $\Delta$t can be calculated as follows:

$$T(t + \Delta t, x) = T(t, x) + k(\Delta t/\Delta x^2)\{T(t, x + \Delta x) -$$

$$2T(t, x) + T(t, x - \Delta x)\} + \{W(t, x)/Cp\rho\}\Delta t$$

where k = $\lambda/Cp\rho$; W(1, x) represents the application of energy from the beam; and Cp, $\rho$, $\lambda$ represent specific heat, a density, and thermal conductivity of the target wafer respectively.

If a circuit pattern is being drawn according to a certain program of electron beam lithography, it is possible to acquire thermal distribution T(t, x, y, z) on the target wafer at certain time by this numerical calculation.

Next, in order to obtain, from the temperature distribution T(t, x, y, z) acquired in such a manner, data (compensation data) required for compensation of a position to which an electron beam should be applied, it is necessary to calculate distortion caused by the thermal expansion of the target wafer. In this case, the areas to be used for the calculation generally have temperatures T that differ from one another, and accordingly thermal expansion of each area differs from the other. Therefore, when calculating deformation of the target wafer constituted of area groups, the deformation is acquired so that a thermal stress of each area becomes minimum.

This calculation can be easily achieved by acquiring an average temperature on each plane, and then by determining a drawing position movement as accumulation of thermal expansion at the average temperature.

For example, when the calculation in a one-dimensional manner is attempted, as shown in Fig. 5, a movement 505 of a certain position L in a x direction at time t caused by thermal expansion is obtained by determining an average temperature T_(y) of a certain area in a xz plane on the assumption that a fixed position 504 is 0, and then by totaling the thermal expansion $\Delta$L (y) with respect to y.

The thermal expansion $\Delta$L(y) can be expressed as follows :

$$\Delta L(y) = \{T\_(y) - T0\}a/Cp\rho$$

Thermal expansion in a y direction can also be acquired by similar calculation. When applying an electron beam to an original position 502, an actual electron beam 503 should be applied to the compensated position. The amount of compensation from the original position to the compensated position can be acquired as a numerical value that represents the amount of deflection 505 from a beam axis 501.

For the purpose of calculation with a higher degree of accuracy including 3-dimensional deformation, numerical calculation is performed for each area using the diffusion equation so as to minimize a thermal stress at that point, and thereby thermal expansion is calculated.

As a result, in response to the program of electron beam lithography, a discrepancy from an original electron beam lithography pattern, which is caused by the thermal expansion, is obtained as a numerical value. Then, this numerical value is used as a correction term from a voltage to an electric current (that is to say, compensation data) which is given to the electron beam deflector 108 of the electron beam lithography system shown in Fig. 1. Therefore, it is possible to compensate the electron-beam applying position in response to the discrepancy in drawing position on the target wafer, which is caused by the thermal expansion.

At this time, not limiting to the electron beam lithography system shown in Fig. 1, in the case of an electron beam lithography system including a specific electron beam deflector used to compensate thermal expansion, this data is used as a numerical value used to control the electron beam deflector. Therefore, it is possible to compensate the electron-beam applying position in response to the discrepancy in drawing position on the target wafer, which is caused by the thermal expansion.

According to the present invention, the application of heat to the target wafer by an electron beam is estimated while taking a time distribution, a positional distribution, and an intensity distribution of the heat are taken into consideration respectively. Then, thermal expansion of a certain target wafer at a certain moment in a drawing program is determined to calculate the amount of compensation of electron beam deflection. Accordingly, a computer simulation by use of given drawing patterns and a given drawing program is used.

In addition, a computer (work station) which is used for this computer simulation is provided inside or outside of the electron beam lithography system, which is operated independently of the drawing program itself. In the case of the embodiment shown in Fig. 1, the thermal-deformation calculating computer 103 is used for the computer simulation.

Numeric data of the discrepancy caused by the determined thermal expansion is inputted into a control workstation of the electron beam lithography system, for instance, the control computer 101 of the embodiment shown in Fig. 1, by means of software. The numeric data is then stored in a given storage device (memory) built into the control workstation. At the time of electron beam lithography that is executed according to a predetermined drawing program, the numeric data is used as compensation data to determine a deflection position of an electron beam.

At this time, a discrepancy of the result of the computer simulation from an actual situation can be compensated by feeding back a large number of electron beam lithography results. Accordingly, it is possible to more practically estimate thermal expansion with a higher degree of accuracy.

Incidentally, as described above, in the case of the embodiment shown in Fig. 1, the thermal-deformation calculating computer 103 calculates beforehand the compensation data by the computer simulation, and then the compensation data obtained is stored in a certain storage device (memory) built into the control computer 101. At the time of electron beam lithography that is executed according to a predetermined drawing program, the compensation data is used as compensation data for determining a deflection position of an electron beam.

This is because if computing speed required for the computer simulation is compared with speed of the electron beam lithography, the former takes longer time. However, it is ideal that this compensation data be calculated concurrently with the electron beam lithography.

It is because if concurrently with the application of an electron beam to the target wafer, heat is given to the target wafer data in the memory in a virtual manner, and the computer simulation progresses in real time accordingly so that compensation data is calculated, a change of the drawing program, a temporary stop, and the like, during the application of the electron beam can also be supported, which makes it possible to obtain a system with high flexibility.

For this reason, one embodiment according to the present invention will be described as below. In this embodiment, a computer simulation is executed concurrently with electron beam lithography, and thereby a change of a drawing program, a temporary stop, and the like, during application of an electron beam can be supported.

Accordingly, it should be noted that in the case of this embodiment, a drawing program used for the electron beam lithography is not limited to a "predetermined drawing program". The drawing program is defined as a "drawing program that is predetermined but can also be changed".

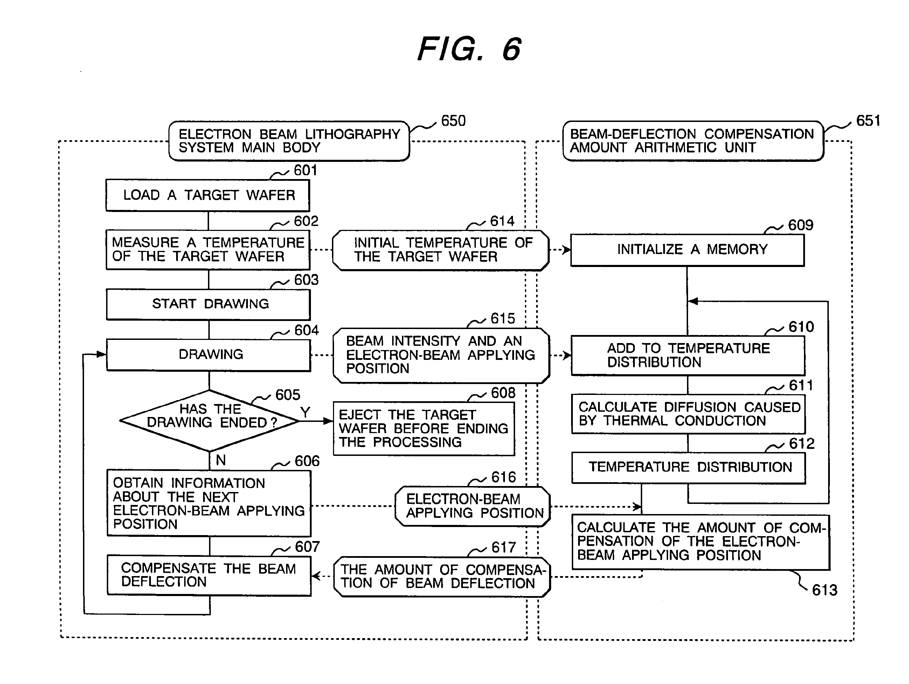

Fig. 6 is a flowchart illustrating an example of processing according to this embodiment. In the case of this embodiment, a target wafer is loaded in an electron beam lithography system main body 650 in a step 601.

Here, it may be thought that this electron beam lithography system main body 650 means the electro-optic system 106 in the embodiment shown in Fig. 1. In this case, the load of the target wafer means the placement of the target wafer 1 on the target holder 2 in the vacuum chamber 108 by use of the target loader 109.

In a step 602, a temperature of the loaded target wafer is measured to create initial temperature distribution data 614 of the target wafer. The initial temperature distribution data 614 is then supplied to an arithmetic unit 651 for calculating the amount of compensation of beam deflection. Here, it may be thought that this beam-deflection compensation amount arithmetic unit 651 is the thermal-deformation calculating computer 103 in the embodiment shown in Fig. 1.

In addition, because a temperature of the target wafer at this time can be considered to be the same as that of the target holder 2, the temperature is generally measured by a temperature sensor provided on the target holder 2.

In the beam-deflection compensation amount arithmetic unit 651, a storage device for storing temperature distribution of the target wafer is initialized using this data in a step 609. It is to be noted that the steps up to this point can also be omitted if the temperature of the target wafer is kept sufficiently uniform while the target wafer is kept in storage, and also if a temperature of the stage is kept the same as the temperature of the target wafer.

In a step 603, drawing on the target wafer by an electron beam is started according to a drawing program. Drawing beam intensity data and drawing position data 615 at this time are always passed to the target-wafer temperature-distribution storage device 651 where current temperature distribution of the target wafer is always calculated and stored as processing of steps 610 and 611.

On the other hand, in the electron beam lithography system main body 650, if it is judged that the drawing continues as a result of a judgment as to whether or not the drawing ends 605, the processing proceeds to a step 606. Next, a position 616 to which an electron beam should be applied is obtained from the drawing program, and the position is then passed to the beam-deflection compensation amount arithmetic unit 651.

Accordingly, in a step 613, the amount of compensation of the beam applying position is calculated according to the position 616. Then, the amount of compensation of beam deflection 617 which has been calculated is returned to the electron beam lithography system main body 650 as compensation data. After that, the beam deflection is compensated in a step 607, and the processing returns to the step 604, the next drawing is performed.

On the completion of the drawing, the processing proceeds from the step 605 to the step 608 where the target wafer is ejected before ending the drawing.

According to this embodiment, because the compensation data is calculated in real time while monitoring a dose, and an applying position of an electron beam, it is possible to flexibly cope with even a case where an electron-beam applying program is changed on the way. This means that it is possible to cope with even a case where, for example, operation of an electron beam source stops during drawing, causing a part of the drawing to be missed.

In this case, it is meant that, for example, if the application of the electron beam to the target wafer is monitored by the existence of a reflection electron, or the like, it is possible to know a change in temperature of the target wafer resulting from an interruption of the electron beam which is being applied, and thereby to calculate practical temperature distribution in response to the change.

In order to eliminate such a state in which a part of the drawing is missed, which should be called an electron-beam missing state, processing such as application of an electron beam should be performed again. However, according to this embodiment, it is possible to easily cope with it because an electron-beam applying program can be changed on the way.

As described above, an object of the present invention is to realize a system that is capable of electron beam lithography with a high degree of accuracy regardless of an increase in temperature of a target wafer. In the case of the above-mentioned embodiment, in order to prevent the accuracy of position from being deteriorated by an increase in temperature of the target wafer, which is inevitability caused by an electron beam, the object is achieved by estimating the temperature distribution of the target wafer with a high degree of accuracy without actually measuring the temperature distribution, and then by controlling deflection of the electron beam in response to the obtained temperature distribution.

To be more specific, in the case of the above-mentioned embodiment, it is possible to provide an electron beam lithography system capable of obtaining the optimum amount of compensation of an electron-beam applying position in association with a dose and the applying position distribution of an electron beam, and also with the temperature distribution and nonuniform expansion of a target wafer which differ according to electron-beam applying time.

Moreover, according to the above-mentioned embodiment, thermal expansion of the target wafer which is thermally isolated can be estimated with a high degree of accuracy. As a result, in spite of the thermal expansion caused by an electron beam, the electron beam lithography can be performed with a high degree of accuracy. Accordingly, the thermal design of a wafer stage is facilitated, which makes it possible to improve the design of the stage with respect to the mechanical accuracy of positioning.

Further, in the case of the present invention, even if an electron-beam applying program for one target wafer is changed, more flexible compensation of an electron-beam applying position becomes possible with increase in speed of a computer simulation. In particular, even at the time of intermittent application of an electron beam, an electron-beam applying position can be flexibly compensated.

According to the present invention, in an electron beam lithography system that applies an electron beam to a target wafer such as a semiconductor wafer, and that thereby draws a pattern circuit, or the like, it is possible to provide an electron beam lithography system and an electron beam lithography method which minimize the effect on drawing discrepancy caused by thermal expansion of the target wafer so as to achieve drawing with a high degree of accuracy.

**Claims**

1. An electron beam lithography system of a type in which an electron beam is scanned according to a predetermined drawing program to draw circuit patterns on a target wafer, said system comprising:

   a calculating means that calculates beforehand thermal deformation occurring in the target wafer, said thermal deformation being caused by applying the electron beam, calculates from the result of the calculation compensation data required to compensate the amount of discrepancy in electron-beam applying position, and then stores the compensation data; and
   a control means that compensates at the time of electron beam lithography, according to the compensation data read out from the calculating means, at least one of a dose and an applying position of the electron beam applied according to the drawing program.

2. An electron beam lithography system of a type in which an electron beam is scanned according to a drawing program that is predetermined but can also be changed to draw circuit patterns on a target wafer, said system comprising:

   a calculating means that calculates thermal deformation occurring in the target wafer, said thermal deformation being caused by the electron beam applied according to the drawing program, and calculates from the result of the calculation compensation data required to compensate the amount of discrepancy in electron-beam applying position; and
   a control means that compensates, according to the compensation data read out from the calculating means, at least one of a dose and an applying position of the electron beam applied according to the drawing program;

   wherein said calculating means calculates the compensation data in real time at the time of electron beam lithography.

3. An electron beam lithography system according to Claim 1 or 2, wherein:

   said calculating means calculates the compensation data by means of computer simulation.

4. An electron beam lithography method of a type in which an electron beam is scanned according to a predetermined drawing program to draw circuit patterns on a target wafer, said method comprising the steps of:

   calculating beforehand thermal deformation occurring in the target wafer, said thermal deformation being caused by the application of the electron beam;
   calculating from the result of the calculation compensation data required to compensate the amount of discrepancy in electron-beam applying position, and then storing the compensation data; and
   compensating at the time of electron beam lithography, according to the compensation data, at least one of a dose and an applying position of the electron beam applied according to the drawing program.

5. An electron beam lithography system of a type in which an electron beam is scanned according to a drawing program that is predetermined but can also be changed to draw circuit patterns on a target wafer, said method comprising the steps of:

   calculating thermal deformation occurring in the target wafer, said thermal deformation being caused by the electron beam applied according to the drawing program;
   calculating from the result of the calculation compensation data required to compensate the amount of discrepancy in electron-beam applying position; and
   compensating, according to the compensation data read out from the calculating means, at least one of a dose and an applying position of the electron beam applied according to the drawing program;

   wherein the compensation data is calculated in real time at the time of electron beam lithography.

6. An electron beam lithography method according to Claim 4 or 5, wherein:

   said step for calculating the compensation data is a step for calculating the compensation data by means of computer simulation.

# FIG. 1

## FIG. 2

## FIG. 3

# FIG. 4

# FIG. 5

## FIG. 6

**ELECTRON BEAM LITHOGRAPHY SYSTEM MAIN BODY** — 650

- 601 LOAD A TARGET WAFER
- 602 MEASURE A TEMPERATURE OF THE TARGET WAFER
- 603 START DRAWING
- 604 DRAWING
- 605 HAS THE DRAWING ENDED?
  - Y → 608 EJECT THE TARGET WAFER BEFORE ENDING THE PROCESSING
  - N → 606 OBTAIN INFORMATION ABOUT THE NEXT ELECTRON-BEAM APPLYING POSITION
- 607 COMPENSATE THE BEAM DEFLECTION

- 614 INITIAL TEMPERATURE OF THE TARGET WAFER
- 615 BEAM INTENSITY AND AN ELECTRON-BEAM APPLYING POSITION
- 616 ELECTRON-BEAM APPLYING POSITION
- 617 THE AMOUNT OF COMPENSATION OF BEAM DEFLECTION

**BEAM-DEFLECTION COMPENSATION AMOUNT ARITHMETIC UNIT** — 651

- 609 INITIALIZE A MEMORY
- 610 ADD TO TEMPERATURE DISTRIBUTION
- 611 CALCULATE DIFFUSION CAUSED BY THERMAL CONDUCTION
- 612 TEMPERATURE DISTRIBUTION
- 613 CALCULATE THE AMOUNT OF COMPENSATION OF THE ELECTRON-BEAM APPLYING POSITION

EP 1 406 291 A2

# FIG. 7